# EUROPEAN PATENT SPECIFICATION

(11) **EP 4 332 591 B1**
(45) Date of publication and mention of the grant of the patent: **26.03.2025**
(21) Application number: 22876769.5
(22) Date of filing: 26.09.2022
(51) Int. Cl.: G09G 3/00

(54) **ELECTRONIC APPARATUS AND METHOD FOR CONTROLLING THEREOF**
ELEKTRONISCHE VORRICHTUNG UND VERFAHREN ZUR STEUERUNG DAVON
APPAREIL ÉLECTRONIQUE ET PROCÉDÉ DE COMMANDE ASSOCIÉ

(30) Priority: 28.09.2021 KR 20210127886
(43) Date of publication of application: 06.03.2024
(73) Proprietor: Samsung Electronics Co., Ltd., Suwon-si, Gyeonggi-do 16677 (KR)
(72) Inventor: KO, Baekseok, Suwon-si Gyeonggi-do 16677 (KR); KIM, Gwanhyung, Suwon-si Gyeonggi-do 16677 (KR); S0H, Byungseok, Suwon-si Gyeonggi-do 16677 (KR)
(74) Representative: Walaski, Jan Filip
(86) International application number: PCT/KR2022/014337
(87) International publication number: WO 2023/054997

(56) References cited:
- KR-A- 20000 039 261
- KR-A- 20100 101 372
- KR-A- 20120 109 325
- KR-A- 20140 069 798
- KR-B1- 102 027 806
- US-A1- 2012 293 455
- US-A1- 2013 082 843
- US-A1- 2017 023 632

## Description

### [Technical Field]

The disclosure relates to an electronic apparatus and a control method thereof. More particularly, the disclosure relates to an electronic apparatus for identifying a defect of a touch panel and a method for controlling thereof.

### [Background Art]

There are various types of touch panels, but capacitive touch panels are most actively used. The capacitive touch panel recognizes a touch based on a change in an electric field existing between two electrodes, and the two electrodes may be implemented in a form of a sheet.

The above information is presented as background information only to assist with an understanding of the disclosure. No determination has been made, and no assertion is made, as to whether any of the above might be applicable as prior art with regard to the disclosure.

US 2012/293455 A1 and KR 2010 0101372 A both disclose an apparatus for and method of testing a touch panel for faults.

### [Disclosure]

### [Technical Problem]

There have been various attempts to identify a defect of an electrode sheet, but the existing defect identification method identifies the defect after assembling by bonding a transmission (TX) electrode sheet and a reception (RX) electrode sheet is finished, and thus there was a limitation that it is impossible to reuse the electrode sheet identified to be defective, and additional work by a user was required because a location where the defect exists was unknown.

Therefore, there is a need for a technology capable of identifying a defect and acquiring a location where the defect exists even before assembling by bonding the electrode sheets constituting a touch panel.

### [Technical Solution]

Aspects of the disclosure are to address at least the above-mentioned problems and/or disadvantages and to provide at least the advantages described below. Accordingly, an aspect of the disclosure is to identify whether a defect exists in a transparent electrode sheet constituting a touch panel based on a signal received from an external device.

Additional aspects will be set forth in part in the description which follows and, in part, will be apparent from the description, or may be learned by practice of the presented embodiments.

In accordance with an aspect of the invention, an electronic apparatus is provided according to claim 1.

In accordance with another aspect of the invention, a method of controlling an electronic apparatus is provided according to claim 8.

The technical problems of the disclosure are not limited to the technical problem described above, and the other technical problems not described will be clearly understood by those skilled in the art from the following description.

### Effect of the Invention

According to various embodiments of the disclosure as described above, the electronic apparatus may identify whether a defect exists in an electrode sheet even before assembling by bonding electrode sheets constituting a touch panel. Also, the electronic apparatus may acquire a location where the defect exists in the electrode sheet.

In addition, effects acquirable or predicted by embodiments of the disclosure are to be disclosed directly or implicitly in the detailed description of the embodiments of the disclosure. For example, various effects predicted according to embodiments of the disclosure will be disclosed in the detailed description to be described below.

Other aspects, advantages, and salient features of the disclosure will become apparent to those skilled in the art from the following detailed description, which, taken in conjunction with the annexed drawings, discloses various embodiments of the disclosure.

### [Description of Drawings]

The above and other aspects, features, and advantages of certain embodiments of the disclosure will be more apparent from the following description taken in conjunction with the accompanying drawings, which:
FIG. 1 is a view illustrating a configuration of a touch panel defect identification system according to an embodiment of the disclosure;
FIG. 2 is a block diagram illustrating a configuration of an electronic apparatus according to an embodiment of the disclosure;
FIG. 3 is a graph illustrating a waveform of a response signal according to an embodiment of the disclosure;
FIG. 4 is a graph illustrating a waveform of a response signal according to an embodiment of the disclosure;
FIG. 5 is a circuit diagram when an electrode sheet is normal according to an embodiment of the disclosure;
FIG. 6 is a circuit diagram when a defect exists in an electrode sheet according to an embodiment of the disclosure;
FIG. 7 is a circuit diagram when a defect exists in an electrode sheet according to an embodiment of the disclosure;
FIG. 8 is a circuit diagram when a defect exists in an electrode sheet according to an embodiment of the disclosure;
FIG. 9 is a graph illustrating a response signal corresponding to the circuit diagram of FIGS. 5 to 8 according to an embodiment of the disclosure;
FIG. 10 is a circuit diagram of an electrode sheet according to an embodiment of the disclosure;
FIG. 11 is a circuit diagram of an electrode sheet according to an embodiment of the disclosure;
FIG. 12 is a graph illustrating a response signal corresponding to the circuit diagrams of FIGS. 10 and 11 according to an embodiment of the disclosure;
FIG. 13 is a circuit diagram of a bonded electrode sheet according to an embodiment of the disclosure;
FIG. 14 is a graph illustrating a signal acquired by an oscilloscope of FIG. 13 according to an embodiment of the disclosure; and
FIG. 15 is a flowchart illustrating a method of controlling an electronic apparatus according to an embodiment of the disclosure.

The same reference numerals are used to represent the same elements throughout the drawings.

### [Best Mode]

The following description with reference to the accompanying drawings is provided to assist in a comprehensive understanding of various embodiments of the disclosure as defined by the claims. It includes various specific details to assist in that understanding, but these are to be regarded as merely exemplary. Accordingly, those of ordinary skill in the art will recognize that various changes and modifications of the various embodiments described herein can be made without departing from the scope of the disclosure as defined by the claims. In addition, descriptions of well-known functions and constructions may be omitted for clarity and conciseness. Accordingly, it should be apparent to those skilled in the art that the following description of various embodiments of the disclosure is provided for illustration purposes only and not for the purpose of limiting the disclosure as defined by the appended claims.

It is to be understood that the singular forms "a," "an," and "the" include plural referents unless the context clearly dictates otherwise. Thus, for example, reference to "a component surface" includes reference to one or more of such surfaces.

The terms used in example embodiments will be briefly explained, and example embodiments will be described in greater detail with reference to the accompanying drawings.

Terms used in the disclosure are selected as general terminologies currently widely used in consideration of the configuration and functions of the disclosure, but may be different depending on intention of those skilled in the art, a precedent, appearance of new technologies, or the like. Further, in specific cases, terms may be arbitrarily selected. In this case, the meaning of the terms will be described in the description of the corresponding embodiments. Accordingly, the terms used in the description should not necessarily be construed as simple names of the terms, but be defined based on meanings of the terms and overall contents of the disclosure.

The example embodiments may vary, and may be provided in different example embodiments. Various example embodiments will be described with reference to accompanying drawings. However, this does not necessarily limit the scope of the various embodiments to a specific embodiment form. Instead, modifications, equivalents and replacements included in the disclosed concept and technical scope of this specification may be employed. While describing various embodiments, if it is identified that the specific description regarding a known technology obscures the gist of the disclosure, the specific description is omitted.

The terms such as "first," "second," and so on may be used to describe a variety of elements, but the elements should not be limited by these terms. The terms used herein are solely intended to explain specific example embodiments, and not to limit the scope of the disclosure.

Singular forms are intended to include plural forms unless the context clearly indicates otherwise. The terms "include", "comprise", "is configured to," etc., of the description are used to indicate that there are features, numbers, steps, operations, elements, parts or combination thereof, and they should not exclude the possibilities of combination or addition of one or more features, numbers, steps, operations, elements, parts or a combination thereof.

The example embodiments of the disclosure will be described in greater detail below in a manner that will be understood by one of ordinary skill in the art. However, various embodiments may be realized in a variety of different configurations, and not limited to descriptions provided herein. Also, well-known functions or constructions are not described in detail since they would obscure the disclosure with unnecessary detail.

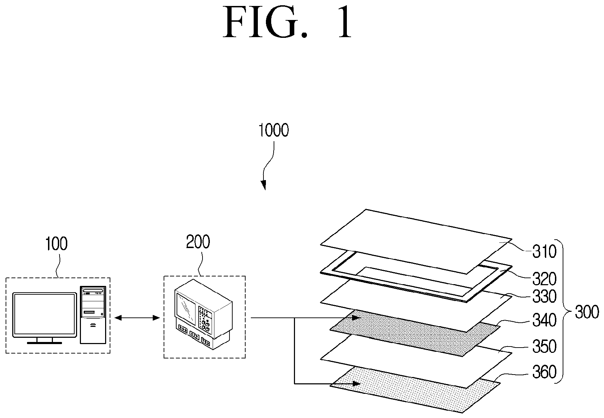

FIG. 1 is a view illustrating a configuration of a touch panel defect identification system according to an embodiment of the disclosure.

Referring to FIG. 1, a touch panel defect identification system 1000 may include an electronic apparatus 100, an external device 200, and a touch panel 300. The touch panel 300 may include an anti-glare (AG) film 310, a cover window 320, an upper optical clear adhesive (OCA) film 330, an upper electrode sheet 340, and a lower OCA film 350 and a lower electrode sheet 360. The electrode sheets 340 and 360 may be transparent. For example, the upper electrode sheet 340 may be a TX electrode sheet, and the lower electrode sheet 360 may be an RX electrode sheet. However, this is only an embodiment, and the upper electrode sheet 340 may be the RX electrode sheet, and the lower electrode sheet 360 may be the TX electrode sheet.

The external device 200 is an impedance measuring device. For example, the external device 200 may include a time domain reflectometer (TDR) device. The external device 200 may apply a first signal to the electrode sheets 340 and 360, and acquire a second signal (i.e., a response signal to the first signal) that the first signal is reflected back from the electrode sheets 340 and 360. The external device 200 may acquire information on the first signal and information on the second signal. Information on each signal may include a voltage magnitude of a signal over time, that is, a waveform of a signal. In the disclosure, the second signal may also be referred to as a response signal.

The electronic apparatus 100 may acquire information on the first signal and information on the second signal by communicating with the external device 200. The electronic apparatus 100 may identify whether a defect exists in the touch panel 300 based on the information on the first signal and the information on the second signal. Although the electronic apparatus 100 is illustrated as a personal computer (PC) in FIG. 1, the disclosure is not limited thereto, and the electronic apparatus 100 may be a mobile device.

Although not shown, the electrode sheets 340 and 360 may be disposed on a printed circuit board (PCB) and may be electrically connected to the external device 200. In addition, a MUX circuit connecting a plurality of lines included in the electrode sheets 340 and 360, and the electronic apparatus 100 may be disposed on the printed circuit board. The electronic apparatus 100 may control the MUX circuit to sequentially apply the first signal to each of the plurality of lines included in the electrode sheet.

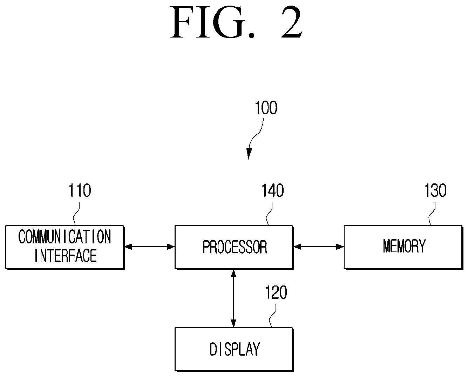

FIG. 2 is a block diagram illustrating a configuration of an electronic apparatus according to an embodiment of the disclosure.

Referring to FIG. 2, the electronic apparatus 100 may include a communication interface 110, a display 120, a memory 130, and a processor 140. The communication interface 110 may include at least one communication circuit and may communicate with an external device or an external server. For example, when a user command for testing a performance of an electrode sheet is acquired, the communication interface 110 may transmit, to the external device, a control signal requesting the external device to apply the first signal to the electrode sheet. Alternatively, the communication interface 110 may transmit a switching control signal to the MUX circuit. The communication interface 110 may also receive, from an external device, information on a first signal applied to the electrode sheet and information on a second signal that is a response signal to the first signal.

The communication interface 110 may include at least one communication terminal. For example, the communication interface 110 may include at least one of a universal serial bus (USB) port, a local area network (LAN) port, and a wide area network (WAN) port. The communication interface 110 may include a wired communication module and a wireless communication module. The wired communication module may include an Ethernet module. Wireless communication modules may include at least one of Bluetooth Low Energy (BLE) module, Wi-Fi communication module, cellular communication module, 3rd generation (3G) mobile communication module, 4th generation (4G) mobile communication module, 4th generation Long Term Evolution (LTE) communication module, 5th generation (5G) mobile communication module.

The display 120 may display various information under a control of the processor 140. For example, the display 120 may display information on defects present in the touch panel or the electrode sheet. The information about the defect may include a type and location of the defect. The display 120 may be implemented as a liquid crystal display panel (LCD), organic light emitting diodes (OLED), etc., and the display 120 may be implemented as a flexible display, a transparent display, or the like. However, the display 120 according to the disclosure is not limited to a specific type.

The memory 130 may store an operating system (OS) for controlling the overall operation of components of the electronic apparatus 100 and commands or data related to components of the electronic apparatus 100. The memory 130 may be implemented as a nonvolatile memory (e.g., a hard disk, a solid state drive (SSD), a flash memory), a volatile memory, or the like.

The memory 130 may store a reference value for identifying the defect of the electrode sheet. For example, the memory 130 may store a predetermined time range. When a difference between a first point at which the first signal is applied to the electrode sheet and a second point at which the second signal is acquired by an external device is outside a predetermined time range (e.g., 10 ns to 12 ns), the processor 140 may identify that there is a defect in the electrode sheet. In the disclosure, the second point at which the second signal is acquired means a point at which a reflection signal corresponding to the first signal is acquired.

The memory 130 may store a predetermined voltage range. When a voltage magnitude of the second signal is outside a predetermined voltage range (e.g., 0.95V to 1.05V), the processor 140 may identify that a defect exists in the electrode sheet. The predetermined time range and the predetermined voltage range may be set by a user.

The processor 140 may be electrically connected to the memory 130 to control overall functions and operations of the electronic apparatus 100. For example, when a user command for inspecting a defect of the electrode sheet is acquired, the processor 140 may control the communication interface 110 to transmit a control signal to an external device. The control signal may be a signal requesting the external device to apply the first signal to a transparent electrode sheet connected to the external device.

The processor 140 may receive information about a first signal from an external device and information about a second signal that is a signal from which the first signal is reflected from the transparent electrode sheet. The information on the first signal may include a first point at which the first signal is applied to the transparent electrode sheet. The information on the second point may receive a second point at which the second signal is acquired by an external device, and a waveform of the second signal.

The processor 140 may identify whether a defect exists in the transparent electrode sheet based on a difference between the first point and the second point and the waveform of the second signal. For example, when the difference between the first point and the second point is outside a predetermined time range, the processor 140 may identify that a defect exists in the transparent electrode sheet. Alternatively, when a voltage magnitude of the second signal is outside a predetermined voltage range, the processor 140 may identify that a defect exists in the transparent electrode sheet.

When the difference between the first point and the second point is less than the predetermined time, and the voltage magnitude of the second signal is less than the predetermined value, the processor 140 may identify that at least some of a plurality of lines included in the transparent electrode sheet are shorted to each other or that at least some of the plurality of lines are shorted to a ground.

When a rise time of the second signal is greater than a predetermined time (e.g., 1 ns to 1.5 ns), the processor 140 may identify that a foreign material is present in the transparent electrode sheet. When a defect test is performed after the transparent electrode sheet is bonded to the other transparent electrode sheet (e.g., the upper electrode sheet 340 and the lower electrode sheet 360 of FIG. 1 are bonded), the rise time of the second signal is greater than the predetermined time, the processor 140 may identify that a degree of compression between the electrode sheets 340 and 360 is outside a predetermined range.

The processor 140 may acquire a location of a defect present in the transparent electrode sheet based on the difference between the first point and the second point. The processor 140 may calculate an impedance of a line based on the difference between the first point and the second point. For example, a line of 60 ohms may correspond to 250 ps. The processor 140 may acquire a length of the line based on the calculated impedance, and may acquire the location of the defect based on the length of the line. Physical properties (e.g., resistivity, conductivity) of the line may be previously stored in the memory 130.

The processor 140 may acquire a similarity between the waveform of the second signal and a predetermined waveform. For example, the processor 140 may acquire the similarity between the waveform of the second signal and predetermined waveform by using a similarity identification algorithm or a neural network model for identifying similarity. In this case, the similarity identification algorithm or the neural network model for identifying the similarity may be previously stored in the memory 130. If the similarity is less than a predetermined value, the processor 140 may identify that a defect exists in the transparent electrode sheet. If the similarity is greater than or equal to the predetermined value, the processor 140 may identify that a defect does not exist in the transparent electrode sheet.

While it is described in the disclosure that the external device 200 is a TDR device, this is only an example, and the external device 200 may be implemented as a jig board using a field programmable gate array (FPGA) or an application-specific integrated circuit (ASIS). The jig board may include a pulse generator that generates a pulse signal to be applied to an electrode sheet, a time-to-digital converter (TDC), and a comparator. The jig board may store information on the pulse signal and the response signal. For example, the jig board may store a first point at which the pulse signal is applied to the jig board, a second point at which the response signal is acquired, a difference between the first point and the second point, and a size of the response signal. The jig board may transmit stored information to the electronic apparatus 100.

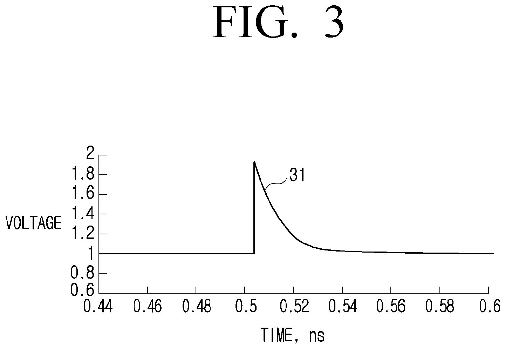

FIG. 3 is a graph illustrating a waveform of a response signal according to an embodiment of the disclosure.

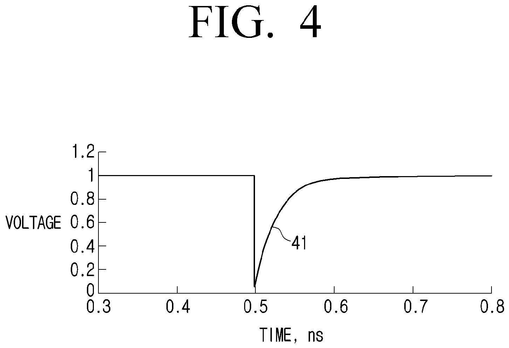

FIG. 4 is a graph illustrating a waveform of a response signal according to an embodiment of the disclosure.

Referring to FIG. 3, a first response signal 31 may have a form in which a voltage magnitude instantaneously increases and then decreases. These waveforms may appear when an inductance of a line exists. For example, when an air gap is formed in the line, the inductance of the line may increase.

Referring to FIG. 4, a second response signal 41 may have a form in which a voltage magnitude instantaneously decreases and then increases. These waveforms may appear when a capacitance of the line is increased. For example, when a foreign matter exists or dents occur in the line, the capacitance of the line may increase. Line dents may occur during bonding by pressing an electrode sheet and an adhesive film.

The electronic apparatus 100 may identify whether a defect exists in the line based on the waveform of the response signal, and may identify a type of the defect. For example, when a waveform of the received response signal has the same shape as the first response signal 31, the electronic apparatus 100 may identify that a defect exists in the line. In this case, the electronic apparatus 100 may identify that an air gap is formed in the line. When a waveform of the received response signal has the same shape as the second response signal 41, the electronic apparatus 100 may identify that a defect exists in the line. In this case, the electronic apparatus 100 may identify that a foreign material is present in the line or that a dent has occurred.

The electronic apparatus 100 may store a waveform of a reference response signal when the electrode sheet is normal. When a difference between a size of the reference response signal and a size of the received response signal is greater than a predetermined value, the electronic apparatus 100 may identify that a defect exists in the line. Alternatively, the electronic apparatus 100 may acquire the inductance or capacitance of the line by analyzing the waveform of the received response signal. When the difference between the acquired inductance or capacitance, and the reference value is greater than a predetermined value, the electronic apparatus 100 may identify that a defect exists in the line.

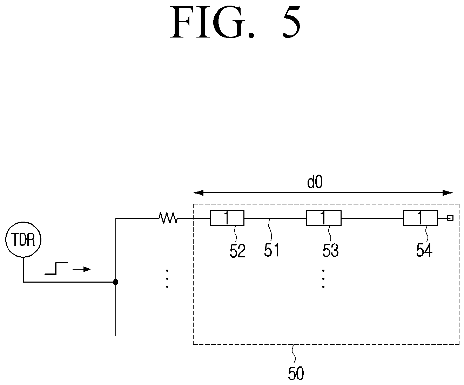

FIG. 5 is a circuit diagram when an electrode sheet is normal according to an embodiment of the disclosure.

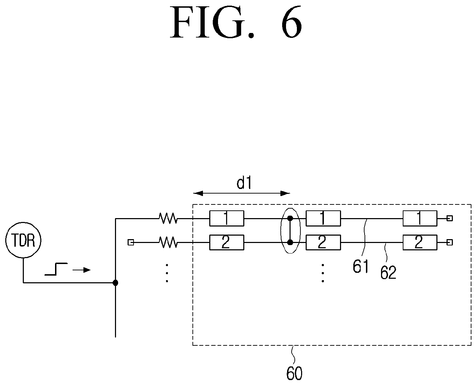

FIGS. 6, 7, and 8 are circuit diagrams when a defect exits in an electrode sheet according to various embodiments of the disclosure.

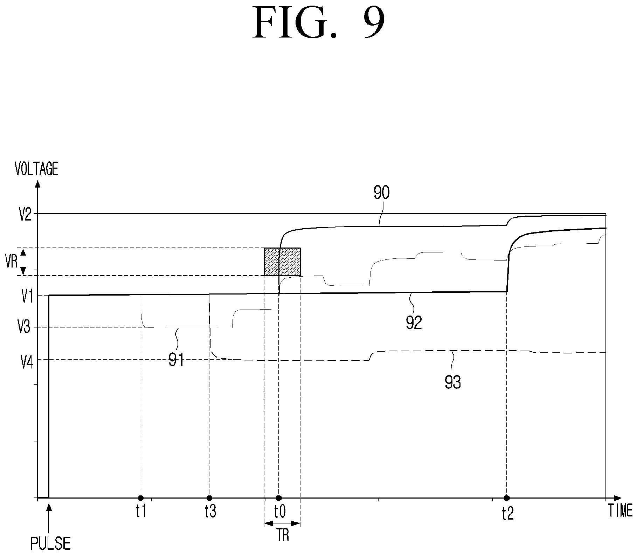

FIG. 9 is a graph illustrating a response signal corresponding to the circuit diagram of FIGS. 5 to 8 according to an embodiment of the disclosure.

Referring to FIGS. 5 to 8, a TDR device may acquire a response signal by applying a pulse signal to an electrode sheet including a plurality of lines. The response signal may be a signal in which the pulse signal is reflected by the electrode sheet. The TDR device may acquire a waveform shown in FIG. 9 and transmit it to the electronic apparatus 100. The electronic apparatus 100 may identify whether a defect exists in the electrode sheet by analyzing the received waveform. Although not illustrated, the electrode sheet may be disposed on a printed circuit board (PCB), and a MUX circuit connecting the plurality of lines included in the electrode sheet and the electronic apparatus 100 may be disposed on the printed circuit board.

Referring to FIG. 5, the electrode sheet 50 may include a plurality of lines. For example, the plurality of lines may include a first line 51. The first line 51 may include a plurality of transmission lines 52, 53, and 54. The first line 51 may have an electrical length of a reference length d0.

Referring to FIG. 9, when a pulse signal is applied to the first line 51, the TDR device may acquire a reference response signal 90. Since the first line 51 is in an open state, a size of the reference response signal 90 may increase up to a first voltage V1 when the pulse signal is applied, and up to a second voltage V2 after a reference point t0. The reference point t0 is a point at which a reflection signal corresponding to the pulse signal applied to the first line 51 is acquired.

The electronic apparatus 100 may identify a first point t0 by analyzing a waveform of the reference response signal 90. For example, the electronic apparatus 100 may identify the first point t0 by identifying a point at which a value acquired by differentiating the reference response signal 90 is greater than a predetermined value. The electronic apparatus 100 may define a reference time range (TR) and a reference voltage range (VR) based on the first point t0. The electronic apparatus 100 may identify whether a defect exists in the electrode sheet by analyzing the response signal based on the reference time range TR and the reference voltage range VR. For example, when a point at which the reflected signal corresponding to the pulse signal is acquired by the TDR device is outside the reference time range TR, or a size of the response signal in the reference time range TR is outside the reference voltage range VR, the electronic apparatus 100 may identify that a defect exists in the electrode sheet.

Referring to FIG. 6, the electrode sheet 60 may include a first line 61 and a second line 62. From the TDR device, the first line 61 and the second line 62 may be shorted at a point where an electrical length is a first length d1.

Referring to FIG. 9, when a pulse signal is applied to the first line 61, the TDR device may acquire a first response signal 91. Since the first line 61 and the second line 62 are shorted from the TDR device at the first length d1 whose electrical length is smaller than the reference length d0, a reflected signal corresponding to the pulse signal applied to the first line 61 may be sensed at a first point t1 that is smaller than a reference point t0. In addition, since the first line 61 and the second line 62 are connected in parallel, an impedance of the first line 61 may be reduced, and a size of the first response signal 91 may be reduced to a third voltage V3 at the first point t1.

The electronic apparatus 100 may identify whether a defect exists in the electrode sheet 60 by analyzing a waveform of the first response signal 91. For example, the electronic apparatus 100 may identify a point at which a value acquired by differentiating the first response signal 91 becomes greater than a predetermined value for the first time, as a first point t1. In addition, the electronic apparatus 100 may identify a change in the size of the first response signal 91 at the first point t1. Since the first point t1 is smaller than the reference point t0 and the third voltage V3 is smaller than the first voltage V1, the electronic apparatus 100 may identify that there is a defect in which the impedance of the first line 61 decreases at a point where the electrical length from the TDR device is smaller than the reference length d0. For example, the electronic apparatus 100 may identify that the first line 61 is shorted with the other line at a point where the electrical length from the TDR device is less than the reference length d0.

The electronic apparatus 100 may acquire a location where a defect exists based on the first point t1. The electronic apparatus 100 may calculate an electrical length of the first line 61 based on the first point t1. For example, the electronic apparatus 100 may calculate the electrical length of the first line 61 by comparing the first point t1 and the reference point t0. The electronic apparatus 100 may identify a location where the reflected signal corresponding to the pulse signal is reflected based on the electrical length of the first line 61.

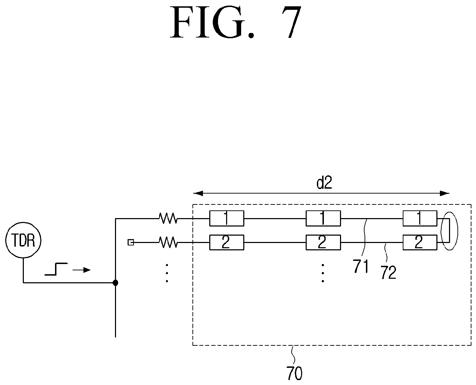

Referring to FIG. 7, an electrode sheet 70 may include a first line 71 and a second line 72. From the TDR device, the first line 71 and the second line 72 may be shorted at a point where the electrical length is a second length d2.

Referring to FIG. 9, when a pulse signal is applied to the first line 71, the TDR device may acquire a second response signal 92. Since the first line 71 and the second line 72 are connected in series such that the electrical length from the TDR device is greater than the reference length d0, a reflected signal corresponding to the pulse signal applied to the first line 71 may be acquired at a second point t2 that is greater than the reference point t0. In addition, since the first line 71 and the second line 72 are in an open state, a size of the second response signal 92 may increase up to the first voltage V1 when the pulse signal is applied, and up to the second voltage V2 after the second point t2.

The electronic apparatus 100 may identify whether a defect exists in the electrode sheet 70 by analyzing a waveform of the second response signal 92. For example, the electronic apparatus 100 may identify a point at which a value acquired by differentiating the second response signal 92 becomes greater than a predetermined value, as the second point t2. Since the second point t2 is greater than the reference point t0, the electronic apparatus 100 may identify that a defect that increases the electrical length of the first line 71 exists in the electrode sheet 70. For example, the electronic apparatus 100 may identify that the first line 71 and the other line are connected in series.

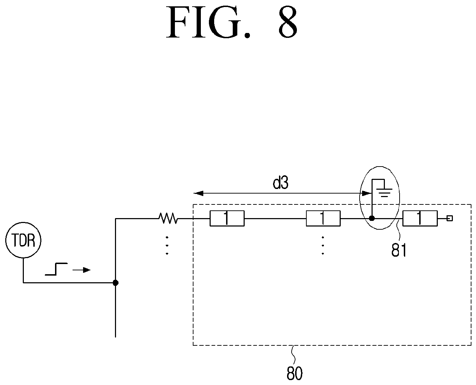

Referring to FIG. 8, an electrode sheet 80 may include a first line 81 and a second line 82. The first line 81 may be shorted to a ground at a point where an electrical length from the TDR device is a third length d3.

Referring to FIG. 9, when a pulse signal is applied to the first line 81, the TDR device may acquire a third response signal 93. Since the first line 81 is shorted to the ground at a third length d3 having an electrical length smaller than the reference length d0 from the TDR device, a third point t3 at which the reflected signal corresponding to the pulse signal applied to the first line 81 is acquired may be smaller than the reference point t0. In addition, since the impedance of the first line 81 is reduced as the first line 81 is shorted to the ground, the size of the third response signal 93 may decrease to a fourth voltage V4 smaller than the first voltage V1 at the third point t3.

The electronic apparatus 100 may identify whether a defect exists in the electrode sheet 80 by analyzing a waveform of the third response signal 93. For example, the electronic apparatus 100 may identify a point at which a value acquired by differentiating the third response signal 93 becomes greater than a predetermined value, as the third point t3. Since the third point t3 is smaller than the reference point t0, the electronic apparatus 100 may identify that a defect in which the electrical length of the first line 81 decreases exists in the electrode sheet 80. In addition, since the size of the third response signal 93 has become smaller than the first voltage V1 after the third point t3, the electronic apparatus 100 may identify that a defect in which the impedance of the first response signal 91 decreases exists. For example, the electronic apparatus 100 may identify that the first line 81 is shorted to the ground at a point corresponding to a third distance d3.

The electronic apparatus 100 may identify whether a defect exists in the upper electrode sheet 340 or the lower electrode sheet 360 even after the upper electrode sheet 340 and the lower electrode sheet 360 are bonded.

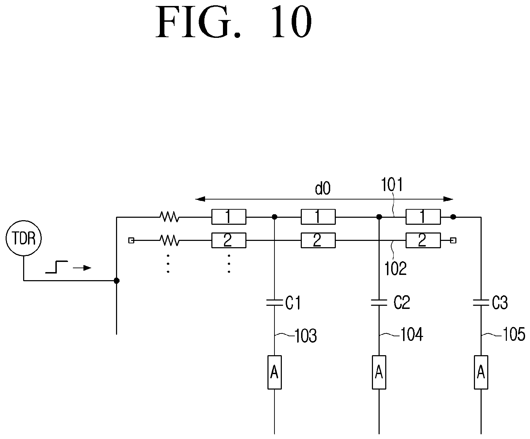

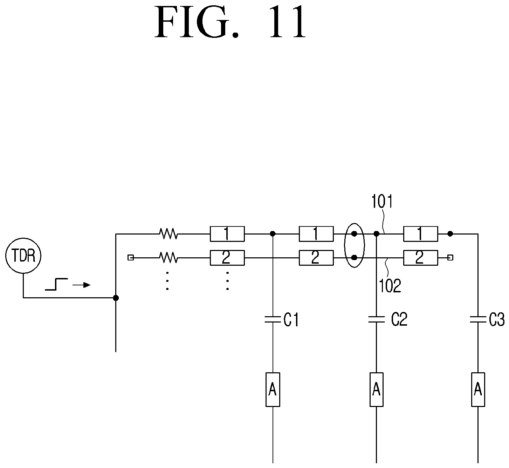

FIGS. 10 and 11 are a circuit diagram of an electrode sheet according to various embodiments of the disclosure.

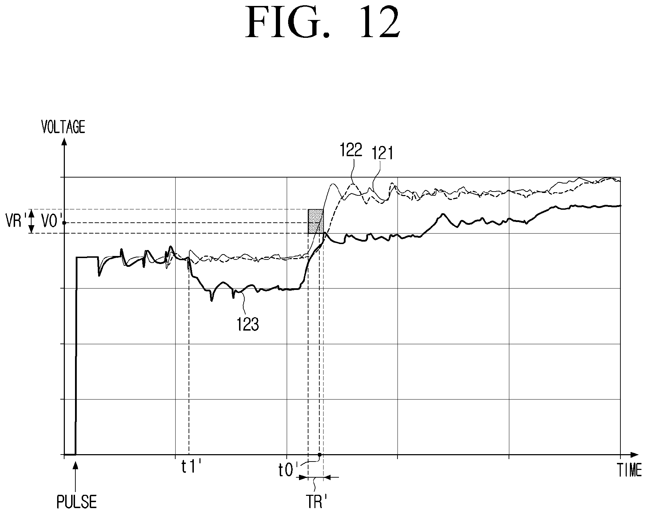

FIG. 12 is a graph illustrating a response signal corresponding to the circuit diagrams of FIGS. 10 and 11 according to an embodiment of the disclosure.

Referring to FIG. 10, horizontal lines 101 and 102 may constitute an upper electrode sheet 340, and vertical lines 103, 104 and 105 may constitute the lower electrode sheet 360. Capacitances C1, C2, and C3 may be formed between the upper electrode sheet 340 and the lower electrode sheet 360. The TDR device may acquire a response signal by applying a pulse signal to the first line 101. For example, a first response signal 121, a second response signal 122, and a third response signal 123 of FIG. 12 may be acquired.

Referring to FIG. 12, the first response signal 121 is a signal when there is no defect in a bonded electrode sheet. The electronic apparatus 100 may define a reference time range TR ', a reference voltage range VR" based on the first response signal 121. For example, the apparatus 100 may identify a reference point at which a size of the first response signal 121 becomes equal to a predetermined value, and the reference time range TR ' based on the reference point Also, the electronic apparatus 100 may define the reference voltage range VR' based on a reference voltage V0' of the first response signal 121 at reference point

The electronic apparatus 100 may identify whether a defect exists in the bonded electrode sheet by analyzing the response signal based on the reference time range TR" and the reference voltage range VR". For example, when a point at which the reflected signal corresponding to the pulse signal is acquired by the TDR device is outside the reference time range TR", or a size of the response signal in the reference time range TR" is outside the reference voltage range VR", the apparatus 100 may identify that a defect exists in the bonded electrode sheet.

The second response signal 122 is a response signal when capacitances C1, C2, and C3 are greater than a predetermined value. As the capacitance increases, a rise time of the response signal may increase. Accordingly, it may be identified that a time for the second response signal 122 to reach the reference voltage V0' is greater than a time for the first response signal 121 to reach the reference voltage V0'.

The electronic apparatus 100 may identify whether a defect exists in the bonded electrode sheet by analyzing a waveform of the response signal. For example, if the response signal is the same as the second response signal 122, the electronic apparatus 100 may identify that there is a defect in which the capacitance increases than a predetermined value, in the bonded electrode sheet,

As shown in the circuit diagram of FIG. 11, the third response signal 123 is a response signal when a short circuit occurs between the lines 101 and 102. Since the first line 101 and the second line 102 are shorted from the TDR device at a point where an electrical length is smaller than a reference length d0, a reflected signal corresponding to a pulse signal applied to the first line 101 may be acquired a first point t1' that is smaller than the point t0'. In addition, since the first line 101 and the second line 102 are connected in parallel, an impedance of the first line 101 may be reduced, and a size of the third response signal 123 may be reduced at the first point t1'.

The electronic apparatus 100 may identify whether a defect exists in the bonded electrode sheet by analyzing a waveform of the response signal. For example, if the response signal is the same as the third response signal 123, the electronic apparatus 100 may identify that there is a defect in which the electrical length and impedance of the first line 101 are reduced.

A method of identifying whether a defect exists in the bonded electrode sheet based on a signal acquired from the upper electrode sheet 340 has been described in FIGS. 11 to 12. However, this is only an embodiment, and the electronic apparatus 100 may identify whether a defect exists in the bonded electrode sheet by analyzing a signal acquired from the lower electrode sheet 360.

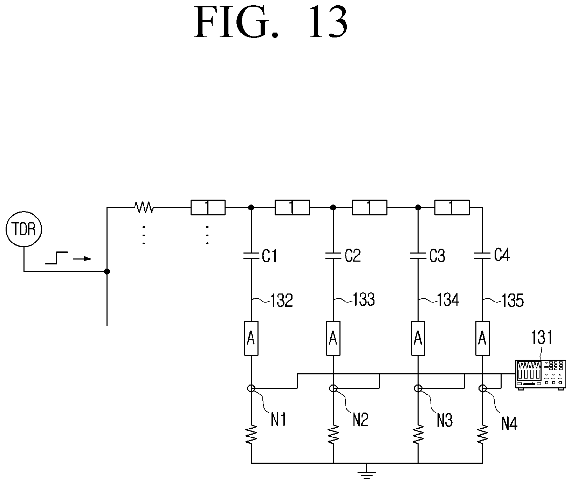

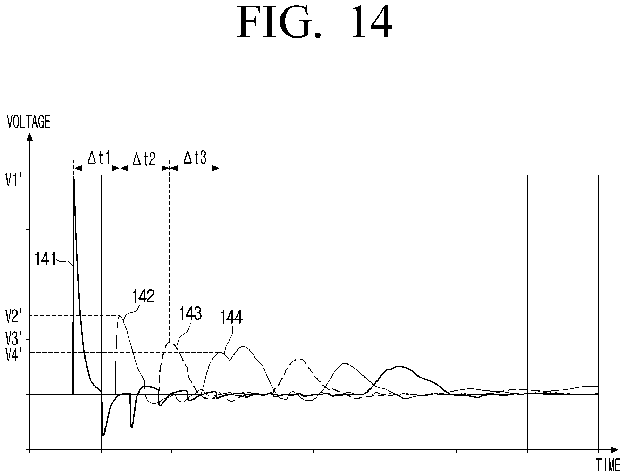

FIG. 13 is a circuit diagram of a bonded electrode sheet according to an embodiment of the disclosure. FIG. 14 is a graph illustrating a signal acquired by the oscilloscope of FIG. 13 according to an embodiment of the disclosure.

Referring to FIG. 13, an oscilloscope 131 may be connected to lines 132, 133, 134, and 135 constituting the lower electrode sheet 360. For example, a probe of the oscilloscope 131 may be coupled to nodes N1, N2, N3, and N4.

Referring to FIG. 14, a first response signal 141 is a signal sensed by a first node N1, a second response signal 142 is a signal sensed by a second node N2, and a third response signal 143 is a signal sensed by a third node N3, and a fourth response signal 144 is a signal sensed by a fourth node N4.

The electronic apparatus 100 may receive a response signal from the oscilloscope 131 and identify whether a defect exists in the bonded electrode sheet by analyzing the response signal. The electronic apparatus 100 may identify whether a defect exists in the bonded electrode sheet by identifying whether the response signal satisfies a predetermined condition. For example, the predetermined condition may include a first condition that a time difference between points at which two adjacent response signals are acquired must be within a predetermined range. When the first condition is satisfied, it means that the capacitors formed between the upper electrode sheet 340 and the lower electrode sheet 360 are formed at regular intervals, that is, uniformly. Accordingly, when the first condition is not satisfied, the electronic apparatus 100 may identify that a defect that a capacitor formed on the bonded electrode sheet is non-uniform exists. The preset condition may include a second condition that a size of the response signal sensed at a location having a greater electrical length from the TDR device should be smaller. When a short occurs between lines included in the bonded electrode sheet, an electrical length may be changed, and accordingly, a point at which a response signal is acquired may change. Accordingly, if the second condition is not satisfied, the electronic apparatus 100 may identify that a defect exists in the bonded electrode sheet. When the first condition and the second condition are satisfied, the electronic apparatus 100 may identify that there is no defect in the bonded electrode sheet.

Referring to FIG. 14, the electronic apparatus 100 may acquire a time difference by comparing a point at which a size of each response signal becomes maximum. The electronic apparatus 100 may acquire a first time difference (Δ*t*1) between a point at which the first response signal 141 is acquired and a point at which the second response signal 142 is acquired. The electronic apparatus 100 may acquire a second time difference (Δ*t*2) between a point at which the second response signal 142 is acquired and a point at which the third response signal 143 is acquired. The electronic apparatus 100 may acquire a third time difference (Δ*t*3) between a point at which the third response signal 143 is acquired and a point at which the fourth response signal 144 is acquired.

The electronic apparatus 100 may identify whether the first condition is satisfied based on the first time difference (Δt1), the second time difference (Δt2), and the third time difference (Δt3). If the first time difference (Δt1), the second time difference (Δt2), and the third time difference (Δt3) are all within a predetermined range (e.g., 0.4 ns to 0.6 ns), the electronic apparatus 100 identifies that the first condition is satisfied. Meanwhile, if at least one of the first time difference (Δt1), the second time difference (Δt2), and the third time difference (Δt3) is out of the predetermined range, the electronic apparatus 100 may identify that the first condition is not satisfied.

The electronic apparatus 100 may identify whether the second condition is satisfied by identifying a maximum value of a size of each response signal and comparing the identified maximum value. For example, the electronic apparatus 100 may identify a first maximum value V1 " the first response signal 141, a second maximum value V2 " of the second response signal 142, and a third maximum value V3 " of the third response signal 143, and a fourth maximum value V4 " of the fourth response signal 144. Since the first maximum value V1' is greater than the second maximum value V2', the second maximum value V2' is greater than the third maximum value V3', and the third maximum value V3' is greater than the maximum value V4', the apparatus 100 may identify that second condition is Accordingly, when a response signal as in FIG. 14 is acquired, the apparatus 100 may identify that is no defect in the bonded circuit. Meanwhile, if the first maximum value V1' is smaller than the second maximum value V2', the apparatus 100 may identify that the second condition is not satisfied.

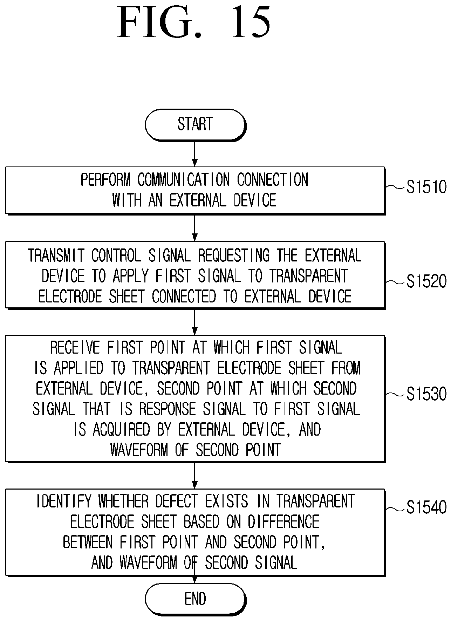

FIG. 15 is a flowchart illustrating a method of controlling an electronic apparatus according to an embodiment of the disclosure.

Referring to FIG. 15, the electronic apparatus 100 may perform communication connection with an external device at operation S1510 and transmit a control signal requesting that the external device applies a first signal to a transparent electrode sheet connected to the external device at operation S1520.

The electronic apparatus 100 may receive a first point at which a first signal is applied to the transparent electrode sheet from the external device, a second point at which a second signal that is a response signal to the first signal is acquired by the external device, and a waveform of the second point at operation S1530.

The electronic apparatus 100 may identify whether a defect exists in the transparent electrode sheet based on a difference between the first point and the second point, and the waveform of the second signal at operation S1540. For example, when the difference between the first point and the second point is outside a predetermined time range, the electronic apparatus 100 may identify that a defect exists in the transparent electrode sheet. Alternatively, when a voltage magnitude of the second signal is outside a predetermined voltage range, the electronic apparatus 100 may identify that a defect exists in the transparent electrode sheet.

When the difference between the first point and the second point is less than the predetermined time, and the voltage magnitude of the second signal is less than the predetermined value, the electronic apparatus 100 may identify that at least some of a plurality of wires included in the transparent electrode sheet are shorted to each other or that at least some of the plurality of wires are shorted to a ground.

When a rise time of the second signal is greater than a predetermined time, the electronic apparatus 100 may identify a foreign material is present in the transparent electrode sheet or that a degree of compression between the transparent electrode sheet and the other transparent electrode sheet is outside a predetermined range.

The electronic apparatus 100 may identify a location of the defect present in the transparent electrode sheet based on the difference between the first point and the second point. The electronic apparatus 100 may display information about the defect including the location of the defect through the display 120.

The electronic apparatus 100 may acquire a similarity between the waveform of the second signal and a predetermined waveform. If the similarity is less than a predetermined value, the electronic apparatus 100 may identify that a defect exists in the transparent electrode sheet. If the similarity is greater than or equal to the predetermined value, the electronic apparatus 100 may identify that a defect does not exist in the transparent electrode sheet.

In addition, various embodiments described above may be implemented in a recording media that may be read by a computer or a similar device to the computer by suing software, hardware, or a combination thereof. In some cases, the embodiments described herein may be implemented by the processor itself. In a software configuration, various embodiments described in the specification such as a procedure and a function may be implemented as separate software modules. The software modules may respectively perform one or more functions and operations described in the disclosure

According to various embodiments described above, computer instructions for performing processing operations of a device according to the various embodiments described above may be stored in a non-transitory computer-readable medium. The computer instructions stored in the non-transitory computer-readable medium may cause a particular device to perform processing operations on the device according to the various embodiments described above when executed by the processor of the particularly device.

The non-transitory computer-readable medium does not refer to a medium that stores data for a short period of time, such as a register, cache, memory, etc., but semi-permanently stores data and is available of reading by the device. For example, the non-transitory computer-readable medium may be compact disc (CD), digital versatile disc (DVD), a hard disc, Blu-ray disc, USB, a memory card, read only memory (ROM), or the like.

While the disclosure has been shown and described with reference to various embodiments thereof, it will be understood by those skilled in the art that various changes in form and details may be made therein without departing from the scope of the disclosure as defined by the appended claims.

## Claims

1. An electronic apparatus comprising:
a communication interface (110) configured to communicate with an external device (200), wherein the external device (200) includes a time domain reflectometer device;
a memory (130); and
a processor (140),
wherein the processor is configured to:
transmit a control signal to the external device requesting the external device to apply a first signal to a transparent electrode sheet for a touch panel (300), the transparent electrode sheet being connected to the external device,
receive, from the external device, a first point at which the first signal is applied to the transparent electrode sheet, a second point at which a second signal that is a response signal to the first signal is acquired by the external device, and a waveform of the second signal, and
identify whether a defect exists in the transparent electrode sheet based on a difference between the first point and the second point, and the waveform of the second signal, **characterised in that**:
based on the difference between the first point and the second point being less than a predetermined time and a voltage magnitude of the second signal being less than a predetermined value, the processor is configured to identify that at least two of a plurality of lines included in the transparent electrode sheet are shorted to each other or at least some of the plurality of lines are shorted to a ground.

2. The apparatus of claim 1, wherein the processor (140) is further configured to, based on the difference between the first point and the second point being outside a predetermined time range, identify that a defect exists in the transparent electrode sheet.

3. The apparatus of claim 1, wherein the processor (140) is further configured to, based on a voltage magnitude of the second signal being outside a predetermined voltage range, identify that a defect exists in the transparent electrode sheet.

4. The apparatus of claim 1, wherein the processor (140) is further configured to, based on a rise time of the second signal being greater than the predetermined time, identify that a foreign material is present in the transparent electrode sheet or a degree of compression between the transparent electrode sheet and another transparent electrode sheet.

5. The apparatus of claim 1, wherein the processor (140) is further configured to acquire a location of the defect existing in the transparent electrode sheet based on the difference between the first point and the second point.

6. The apparatus of claim 1, wherein the processor (140) is further configured to:
acquire a similarity between the waveform of the second signal and a predetermined waveform;
based on the similarity being less than the predetermined value, identify that a defect exists in the transparent electrode sheet; and
based on the similarity being greater than or equal to the predetermined value, identify that there is no defect in the transparent electrode sheet.

7. The apparatus of claim 1, further comprising:
a display (120),
wherein the processor (140) is further configured to, based on a defect being identified to be existed in the transparent electrode sheet, control the display to display information on the defect.

8. A method of controlling an electronic apparatus, the method comprising:
performing a communication connection with an external device (200), wherein the external device (200) includes a time domain reflectometer device;
transmitting a control signal to the external device requesting the external device to apply a first signal to a transparent electrode sheet for a touch panel (300), the transparent electrode sheet being connected to the external device;
receiving, from the external device, a first point at which the first signal is applied to the transparent electrode sheet, a second point at which a second signal that is a response signal to the first signal is acquired by the external device, and a waveform of the second signal; and
identifying whether a defect exists in the transparent electrode sheet based on a difference between the first point and the second point, and the waveform of the second signal, **characterised by**:
based on the difference between the first point and the second point being less than a predetermined time and a voltage magnitude of the second signal being less than a predetermined value, identifying that at least some of a plurality of lines included in the transparent electrode sheet are shorted to each other or at least some of the plurality of lines are shorted to a ground.

9. The method of claim 8, wherein the identifying of whether the defect exists includes, based on the difference between the first point and the second point being outside a predetermined time range, identifying that a defect exists in the transparent electrode sheet.

10. The method of claim 8, wherein the identifying of whether the defect exists includes, based on a voltage magnitude of the second signal being outside a predetermined voltage range, identifying that a defect exists in the transparent electrode sheet.

11. The method of claim 8, wherein the identifying of whether the defect exists includes, based on a rise time of the second signal being greater than the predetermined time, identifying that a foreign material is present in the transparent electrode sheet or a degree of compression between the transparent electrode sheet and another transparent electrode sheet.

12. The method of claim 8, wherein the identifying of whether the defect exists includes acquiring a location of the defect existing in the transparent electrode sheet based on the difference between the first point and the second point.

13. The method of claim 8, wherein the identifying of whether the defect exists includes:
acquiring a similarity between the waveform of the second signal and a predetermined waveform;
based on the similarity being less than the predetermined value, identifying that a defect exists in the transparent electrode sheet; and
based on the similarity being greater than or equal to the predetermined value, identifying that there is no defect in the transparent electrode sheet.

## Patentansprüche

1. Elektronische Vorrichtung, umfassend:
eine Kommunikationsschnittstelle (110), die dazu konfiguriert ist, mit einer externen Einrichtung (200) zu kommunizieren, wobei die externe Einrichtung (200) eine Zeitbereichsreflektometereinrichtung enthält;
einen Speicher (130); und
einen Prozessor (140),
wobei der Prozessor zu Folgendem konfiguriert ist:
Übertragen eines Steuersignals an die externe Einrichtung, das die externe Einrichtung auffordert, ein erstes Signal an eine transparente Elektrodenfolie für ein Berührungsfeld (300) anzulegen, wobei die transparente Elektrodenfolie mit der externen Einrichtung verbunden ist, Empfangen, von der externen Einrichtung, eines ersten Punktes, an dem das erste Signal an die transparente Elektrodenfolie angelegt wird, eines zweiten Punktes, an dem ein zweites Signal, das ein Antwortsignal auf das erste Signal ist, durch die externe Einrichtung erfasst wird, und einer Wellenform des zweiten Signals, und
Identifizieren, ob ein Defekt in der transparenten Elektrodenfolie vorliegt, basierend auf einer Differenz zwischen dem ersten Punkt und dem zweiten Punkt und der Wellenform des zweiten Signals, **dadurch gekennzeichnet, dass**:
basierend darauf, dass die Differenz zwischen dem ersten Punkt und dem zweiten Punkt kleiner als eine vorbestimmte Zeit ist und eine Spannungsgröße des zweiten Signals kleiner als ein vorbestimmter Wert ist, der Prozessor dazu konfiguriert ist, zu identifizieren, dass mindestens zwei von einer Vielzahl von Leitungen, die in der transparenten Elektrodenfolie enthalten ist, miteinander kurzgeschlossen sind oder dass mindestens einige der Vielzahl von Leitungen mit einer Masse kurzgeschlossen sind.

2. Vorrichtung nach Anspruch 1, wobei der Prozessor (140) ferner dazu konfiguriert ist, basierend darauf, dass die Differenz zwischen dem ersten Punkt und dem zweiten Punkt außerhalb eines vorbestimmten Zeitbereichs liegt, zu identifizieren, dass ein Defekt in der transparenten Elektrodenfolie vorliegt.

3. Vorrichtung nach Anspruch 1, wobei der Prozessor (140) ferner dazu konfiguriert ist, basierend darauf, dass eine Spannungsgröße des zweiten Signals außerhalb eines vorbestimmten Spannungsbereichs liegt, zu identifizieren, dass ein Defekt in der transparenten Elektrodenfolie vorliegt.

4. Vorrichtung nach Anspruch 1, wobei der Prozessor (140) ferner dazu konfiguriert ist, basierend darauf, dass eine Anstiegszeit des zweiten Signals größer als die vorbestimmte Zeit ist, zu identifizieren, dass eine Fremdsubstanz in der transparenten Elektrodenfolie vorhanden ist, oder eines Kompressionsgrads zwischen der transparenten Elektrodenfolie und einer anderen transparenten Elektrodenfolie.

5. Vorrichtung nach Anspruch 1, wobei der Prozessor (140) ferner dazu konfiguriert ist, einen Ort des Defekts, der in der transparenten Elektrodenfolie vorliegt, basierend auf der Differenz zwischen dem ersten Punkt und dem zweiten Punkt zu erfassen.

6. Vorrichtung nach Anspruch 1, wobei der Prozessor (140) ferner zu Folgendem konfiguriert ist:
Erfassen einer Ähnlichkeit zwischen der Wellenform des zweiten Signals und einer vorbestimmten Wellenform;
basierend darauf, dass die Ähnlichkeit kleiner als der vorbestimmte Wert ist, Identifizieren, dass ein Defekt in der transparenten Elektrodenfolie vorliegt; und
basierend darauf, dass die Ähnlichkeit größer als oder gleich dem vorbestimmten Wert ist, Identifizieren, dass es keinen Defekt in der transparenten Elektrodenfolie gibt.

7. Vorrichtung nach Anspruch 1, ferner umfassend:
eine Anzeige (120),
wobei der Prozessor (140) ferner dazu konfiguriert ist, basierend darauf, dass identifiziert wird, dass ein Defekt in der transparenten Elektrodenfolie vorliegt, die Anzeige so zu steuern, dass sie Informationen über den Defekt anzeigt.

8. Verfahren zum Steuern einer elektronischen Vorrichtung, wobei das Verfahren Folgendes umfasst:
Durchführen einer Kommunikationsverbindung mit einer externen Einrichtung (200), wobei die externe Einrichtung (200) eine Zeitbereichsreflektometereinrichtung enthält;
Übertragen eines Steuersignals an die externe Einrichtung, das die externe Einrichtung auffordert, ein erstes Signal an eine transparente Elektrodenfolie für ein Berührungsfeld (300) anzulegen, wobei die transparente Elektrodenfolie mit der externen Einrichtung verbunden ist;
Empfangen, von der externen Einrichtung, eines ersten Punktes, an dem das erste Signal an die transparente Elektrodenfolie angelegt wird, eines zweiten Punktes, an dem ein zweites Signal, das ein Antwortsignal auf das erste Signal ist, durch die externe Einrichtung erfasst wird, und einer Wellenform des zweiten Signals; und
Identifizieren, ob ein Defekt in der transparenten Elektrodenfolie vorliegt, basierend auf einer Differenz zwischen dem ersten Punkt und dem zweiten Punkt und der Wellenform des zweiten Signals, **gekennzeichnet durch**:
basierend darauf, dass die Differenz zwischen dem ersten Punkt und dem zweiten Punkt kleiner als eine vorbestimmte Zeit ist und eine Spannungsgröße des zweiten Signals kleiner als ein vorbestimmter Wert ist, Identifizieren, dass mindestens einige einer Vielzahl von Leitungen, die in der transparenten Elektrodenfolie enthalten ist, miteinander kurzgeschlossen sind oder dass mindestens einige der Vielzahl von Leitungen mit einer Masse kurzgeschlossen sind.

9. Verfahren nach Anspruch 8, wobei das Identifizieren, ob der Defekt vorliegt, Identifizieren, dass ein Defekt in der transparenten Elektrodenfolie vorliegt, basierend darauf, dass die Differenz zwischen dem ersten Punkt und dem zweiten Punkt außerhalb eines vorbestimmten Zeitbereichs liegt, enthält.

10. Verfahren nach Anspruch 8, wobei das Identifizieren, ob der Defekt vorliegt, Identifizieren, dass ein Defekt in der transparenten Elektrodenfolie vorliegt, basierend darauf, dass eine Spannungsgröße des zweiten Signals außerhalb eines vorbestimmten Spannungsbereichs liegt, enthält.

11. Verfahren nach Anspruch 8, wobei das Identifizieren, ob der Defekt vorliegt, Identifizieren, dass eine Fremdsubstanz in der transparenten Elektrodenfolie vorhanden ist, oder eines Kompressionsgrads zwischen der transparenten Elektrodenfolie und einer anderen transparenten Elektrodenfolie, basierend darauf, dass eine Anstiegszeit des zweiten Signals größer als die vorbestimmte Zeit ist, enthält.

12. Verfahren nach Anspruch 8, wobei das Identifizieren, ob der Defekt vorliegt, Erfassen eines Orts des Defekts, der in der transparenten Elektrodenfolie vorliegt, basierend auf der Differenz zwischen dem ersten Punkt und dem zweiten Punkt enthält.

13. Verfahren nach Anspruch 8, wobei das Identifizieren, ob der Defekt vorliegt, Folgendes enthält:
Erfassen einer Ähnlichkeit zwischen der Wellenform des zweiten Signals und einer vorbestimmten Wellenform;
basierend darauf, dass die Ähnlichkeit kleiner als der vorbestimmte Wert ist, Identifizieren, dass ein Defekt in der transparenten Elektrodenfolie vorliegt; und
basierend darauf, dass die Ähnlichkeit größer als oder gleich dem vorbestimmten Wert ist, Identifizieren, dass es keinen Defekt in der transparenten Elektrodenfolie gibt.

## Revendications

1. Appareil électronique comprenant :
une interface de communication (110) configurée pour communiquer avec un dispositif externe (200), ledit dispositif externe (200) comprenant un dispositif de réflectomètre dans le domaine temporel ;
une mémoire (130) ; et
un processeur (140),
ledit processeur étant configuré pour :
transmettre un signal de commande au dispositif externe demandant au dispositif externe d'appliquer un premier signal à une feuille d'électrode transparente pour un panneau tactile (300), la feuille d'électrode transparente étant connectée au dispositif externe,
recevoir, en provenance du dispositif externe, un premier point au niveau duquel le premier signal est appliqué à la feuille d'électrode transparente, un second point au niveau duquel un second signal qui est un signal de réponse au premier signal est acquis par le dispositif externe, et une forme d'onde du second signal, et
identifier si un défaut existe dans la feuille d'électrode transparente sur la base d'une différence entre le premier point et le second point, et la forme d'onde du second signal, **caractérisé en ce que** :
sur la base que la différence entre le premier point et le second point est inférieure à un temps prédéfini et qu'une amplitude de tension du second signal est inférieure à une valeur prédéfinie, le processeur est configuré pour identifier qu'au moins deux d'une pluralité de lignes comprises dans la feuille d'électrode transparente sont court-circuitées l'une avec l'autre ou qu'au moins certaines de la pluralité de lignes sont court-circuitées avec une masse.

2. Appareil de la revendication 1, ledit processeur (140) étant en outre configuré pour, sur la base que la différence entre le premier point et le second point est en dehors d'une plage de temps prédéfinie, identifier qu'un défaut existe dans la feuille d'électrode transparente.

3. Appareil de la revendication 1, ledit processeur (140) étant en outre configuré pour, sur la base qu'une amplitude de tension du second signal est en dehors d'une plage de tension prédéfinie, identifier qu'un défaut existe dans la feuille d'électrode transparente.

4. Appareil de la revendication 1, ledit processeur (140) étant en outre configuré pour, sur la base qu'un temps de montée du second signal est supérieur au temps prédéfini, identifier qu'un matériau étranger est présent dans la feuille d'électrode transparente ou un degré de compression entre la feuille d'électrode transparente et une autre feuille d'électrode transparente.

5. Appareil de la revendication 1, ledit processeur (140) étant en outre configuré pour acquérir un emplacement du défaut existant dans la feuille d'électrode transparente sur la base de la différence entre le premier point et le second point.

6. Appareil de la revendication 1, ledit processeur (140) étant en outre configuré pour :
acquérir une similitude entre la forme d'onde du second signal et une forme d'onde prédéfinie ;
sur la base que la similarité est inférieure à la valeur prédéfinie, identifier qu'un défaut existe dans la feuille d'électrode transparente ; et
sur la base que la similarité qui est supérieure ou égale à la valeur prédéfinie, identifier qu'aucun défaut n'existe dans la feuille d'électrode transparente.

7. Appareil de la revendication 1, comprenant en outre :
un dispositif d'affichage (120),
ledit processeur (140) étant en outre configuré pour, sur la base qu'un défaut est identifié comme existant dans la feuille d'électrode transparente, commander le dispositif d'affichage pour afficher des informations sur le défaut.

8. Procédé de commande d'un appareil électronique, le procédé comprenant : la réalisation d'une connexion de communication avec un dispositif externe (200), le dispositif externe (200) comprenant un dispositif de réflectomètre dans le domaine temporel ;
la transmission d'un signal de commande au dispositif externe demandant au dispositif externe d'appliquer un premier signal à une feuille d'électrode transparente pour un panneau tactile (300), la feuille d'électrode transparente étant connectée au dispositif externe ;
la réception, en provenance du dispositif externe, d'un premier point au niveau duquel le premier signal est appliqué à la feuille d'électrode transparente, d'un second point au niveau duquel un second signal qui est un signal de réponse au premier signal est acquis par le dispositif externe, et d'une forme d'onde du second signal ; et
l'identification pour savoir si un défaut existe dans la feuille d'électrode transparente sur la base d'une différence entre le premier point et le second point, et la forme d'onde du second signal, **caractérisé par** :
sur la base que la différence entre le premier point et le second point est inférieure à un temps prédéfini et qu'une amplitude de tension du second signal est inférieure à une valeur prédéfinie, l'identification qu'au moins certaines d'une pluralité de lignes comprises dans la feuille d'électrode transparente sont court-circuitées l'une avec l'autre ou qu'au moins certaines de la pluralité de lignes sont court-circuitées avec une masse.

9. Procédé de la revendication 8, ladite identification de l'existence ou non du défaut comprenant, sur la base que la différence entre le premier point et le second point est en dehors d'une plage de temps prédéfinie, l'identification qu'un défaut existe dans la feuille d'électrode transparente.

10. Procédé de la revendication 8, ladite identification de l'existence ou non du défaut comprenant, sur la base qu'une amplitude de tension du second signal est en dehors d'une plage de tension prédéfinie, l'identification qu'un défaut existe dans la feuille d'électrode transparente.

11. Procédé de la revendication 8, ladite identification de l'existence ou non du défaut comprenant, sur la base qu'un temps de montée du second signal est supérieur au temps prédéfini, l'identification qu'un matériau étranger est présent dans la feuille d'électrode transparente ou d'un degré de compression entre la feuille d'électrode transparente et une autre feuille d'électrode transparente.

12. Procédé de la revendication 8, ladite identification de **l'existence** ou non du défaut comprenant l'acquisition d'un emplacement du défaut existant dans la feuille d'électrode transparente sur la base de la différence entre le premier point et le second point.

13. Procédé de la revendication 8, ladite identification de l'existence ou non du défaut comprenant :
l'acquisition d'une similitude entre la forme d'onde du second signal et une forme d'onde prédéfinie ;
sur la base que la similarité est inférieure à la valeur prédéfinie, l'identification qu'un défaut existe dans la feuille d'électrode transparente ; et
sur la base que la similarité est supérieure ou égale à la valeur prédéfinie, l'identification qu'aucun défaut n'existe dans la feuille d'électrode transparente.
